Europäisches Patentamt

European Patent Office

Office européen des brevets

(19)

(11) Publication number: **0 295 659 B1**

# EUROPEAN PATENT SPECIFICATION

(12)

(45) Date of publication of the patent specification:
**05.09.90**

(51) Int. Cl.⁵: **H01L 21/368, C03B 19/04, C30B 29/48**

(21) Application number: **88109560.8**

(22) Date of filing: **15.06.88**

(54) Process for making single-crystal mercury cadmium telluride layers.

(30) Priority: **16.06.87 IT 6751987**

(43) Date of publication of application:
**21.12.88 Bulletin 88/51**

(45) Publication of the grant of the patent:
**05.09.90 Bulletin 90/36**

(84) Designated Contracting States:
**BE DE FR GB NL SE**

(56) References cited:
**GB-A- 2 132 228
US-A- 4 642 142**

**JOURNAL OF CRYSTAL GROWTH, vol. 80, no. 1,
January 1987, pages 1-8, Elsevier Science Publishers
B.V., (North-Holland Physics Publishing Division),
Amsterdam, NL; M. ASTLES et al.: "The use of in-situ
wash melts in the LPE growth of (CdHg)Te"
JOURNAL OF THE ELECTROCHEMICAL SOCIETY,
vol. 130, no. 1, January 1983, pages 228-230,
Manchester, New Hampshire, US; H. RUDA et al.:
"Mecury pressure-induced LPE growth of HgCdTe"
PATENT ABSTRACTS OF JAPAN, vol. 7,
no. 65 (E-165)[1210], 18th March 1983 & JP-A-57-211 725**

(73) Proprietor: **SELENIA INDUSTRIE ELETTRONICHE
ASSOCIATE S.p.A., Via Fusaro, 187, I-80070 Bacoli
(Napoli)(IT)**

(72) Inventor: **Bernardi, Sergio, Via Chambery, 80/C,
Torino(IT)**

(74) Representative: **Riederer Freiherr von Paar zu Schönau,
Anton et al, Van der Werth, Lederer & Riederer
Freyung 615 Postfach 2664, D-8300 Landshut(DE)**

## Description

The present invention relates to industrial processes for preparing semiconductor materials for optoelectronic devices and more particularly it concerns a process for making single-crystal mercury cadmium telluride layers.

Nowadays this material is considered very suited to fabricate optoelectronic devices operating at high wavelengths (2-40 µm). More particularly, due to low energy gap between valence and conduction bands, it is suited to fabricate photodetectors for infrared radiations with wavelengths ranging within 8 and 14 µm, when it has a composition of about 10% in weight of cadmium. In fact, the energy necessary to produce electron-hole pairs in the semiconductor is of only 0.1 eV for the cited composition. Optoelectronic devices can thus be fabricated for detecting low-energy radiations, such as, for instance, those emitted by any object at room temperature.

Mono- or bidimensional arrays forming the photosensitive elements of high-performance imaging systems can be obtained by devices of this kind. Said systems can supply thermal images useful in various applications, by instance illness diagnosis, terrestrial pollution mapping from on board the satellites, sighting of objects or people under poor visibility conditions, etc.

As known high-performance electronic devices are fabricated using a basic semiconductor material available as single crystal. In fact only in this case the material presents physical properties constant and well known in each point of its volume, that is why the performances of the devices obtained therefrom may be optimized. Besides, the single crystal obtained must prevent a lattice periodicity as perfect as possible, in order to avoid undesired reductions in the quantic efficiency of photodetection.

Such characteristics can be better obtained by epitaxial growth techniques, which allow also the implantation of wide surfaces necessary to the fabrication of photodetector arrays. Liquid and vapour phase techniques are well known. The former are nowadays the most-widely used.

Liquid-phase epitaxial growth consists of the deposition on a single crystal substrate of alloys with compositions depending on those of suitable growth solutions. Starting from solutions wherein melted tellurium acts as solvent and cadmium and mercury as solutes, single-crystal layers of the ternary mercury cadmium telluride compound are deposited on the binary cadmium telluride compound, generally used as substrate. The deposition takes place bringing the substrate into contact with the slightly supersaturated solution.

Growth solution has been till now prepared in a cycle different from that in which epitaxial growth takes place. The preparation method consisted of sealing in a quartz ampoule convenient quantities of tellurium, cadmium and mercury, of homogenizing them at a temperature higher than 500 °C for some tens hours, and of rapidly quenching them to preserve the homogeneous composition of the liquid. Parts of this alloy were then used as growth solutions in a subsequent cycle of epitaxial deposition on a single-crystal substrate.

Unluckily, all techniques of growing cadmium and mercury telluride are highly complicated by the strong tendency of mercury to evaporate.

This characteristic is favoured by the necessity of causing the growth process to evolve at temperatures higher than the melt temperature of solvent tellurium, equal to about 500 °C. Mercury evaporation causes variations during growth thermal cycles both in single crystal solid, and in the solution it is generated by (for liquid-phase techniques).

To overcome this disadvantage different methods have been suggested to protect the solution composition. A method described in "Semiconductors and Semimetals", Academic Press, Vol. 18, 1981, pages 70-84, suggests to insert in a sealed ampoule both the solution and the substrate, on which the deposition is effected by bringing into contact solution and solid.

However such a method has nowadays been abandoned owing to the difficulties encountered in controlling growth phases inside the closed ampoule and to the impossibility of implanting structures with different composition layers.

According to another method, described by T.C. Harman in the papers issued in Journal of Electronic Materials, Vol. 9, No. 6, pages 945-961 and Vol. 10, No. 6, pages 1069-1085 solution and substrate are placed into a reactor with hydrogen atmosphere at atmospheric pressure and the solution composition is preserved by means of a mercury source inside the reactor itself. The source consists of a mercury bath maintained at a lower temperature than that of the growth solution, but such as to produce a partial mercury vapour pressure equal to that of solution equilibrium. That is obtained by placing the reactor into a furnace with two zones at different temperatures. This method, according to the known literature, requires the solution to be prepared in a phase preceding the growth phase. Preparing the solution in a sealed ampoule can give rise to inconvenients due to possible contaminations of the solution during handling and certainly the process is longer and so industrially less interesting.

The disadvantages above are overcome by the process for the fabrication of single-crystal mercury cadmium telluride layers, provided by the present invention, which permits implementing in a single phase both the preparation of the growth solution and the epitaxial growth, thus completely avoiding the operations of preparing the ampoule, which are long and detrimental to material purity. Besides it allows fabricating multilayer structures utilizing different-composition growth solutions.

The present invention provides a process for fabricating single-crystal mercury cadmium telluride layers by epitaxial growth on a cadmium telluride substrate, performed inside a reactor with two communicating zones maintained at different and controlled temperatures, characterized in that:

- weighed amounts of cadmium and tellurium are placed in a well inside the reactor in the higher-temperature zone and are melted and homogenized, so as to obtain a solution of cadmium in tellurium;

- a mercury bath is placed inside the reactor in the lower-temperature zone and is heated so as to obtain a mercury vapour atmosphere in the whole reactor;

- due to the absorption of vapour state mercury, the above solution is converted into a solution of cadmium and mercury in tellurium and homogenized as an effect of thermal agitation at the higher temperature;

- solution and mercury bath are slowly cooled down so as to produce the solution supersaturation and keep its composition constant;

- the substrate is brought into contact with the solution and the epitaxial growth of single-crystal mercury cadmium telluride is carried out.

The foregoing and other properties of the present invention will be made clearer by the following description of a preferred embodiment thereof, given by way of example and not in a limiting sense, and by the annexed drawings, in which:

- Fig. 1 is a schematic representation of a reactor for epitaxial growths;
- Fig. 2 is a time diagram repressenting temperature profiles of the baths contained in the reactor.

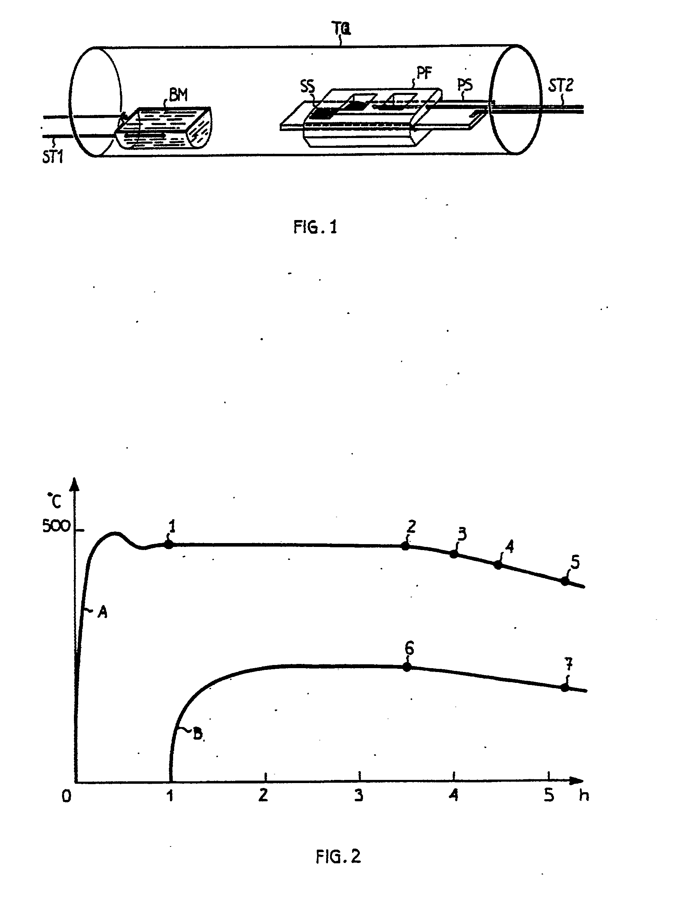

The reactor, schematically represented in Fig.1, consists of a quartz tube TQ, wherein an overpure hydrogen flow is maintained under atmospheric pressure, in order to avoid oxidative phenomena. On the left there is a mercury bath BM, maintained at temperature THg, and on the right the growth crucible. The latter comprises a slider PS, housing a cadmium telluride substrate SS, and a fixed part PF containing two wells for growth solutions, kept at temperature Tso1. During the process different-composition solutions can be produced in both wells, whenever different composition layers are desired, or an only solution is possible in one of the two wells.

ST1 and ST2 denote two temperature probes, permitting an accurate measurement of the mercury bath and of the growth solution temperatures. Moreover, a two-zone furnace, not represented in the Figure, surrounds the quartz tube so as to maintain mercury bath and solution above temperatures THg and Tsol.

After attaining optimal growth conditions, the solution composed of tellurium, cadmium and mercury in the desired percentages is brought into contact with the substrate moving crucible slider PS and is kept in this position for the time necessary to deposit the wanted thickness of mercury cadmium telluride.

The invention deals with the process part which precedes the epitaxial growth and particularly concerns the way of generating the desired growth solution, starting from a solution of cadmium in tellurium and a mercury bath, following a particular thermal cycle under suitable conditions.

A well of the growth crucible is filled with weighted amounts of cadmium and tellurium and substrate SS is placed on the slider PS. The composition of the two-component solution is determined according to known methods (see e.g. the already cited papers by T.G. Harman) in function of the composition of desired solid layers.

The growth crucible without the mercury bath is introduced into the quartz tube raised to operative thermal conditions by the two-zone furnace. The crucible is then at a temperature of about 500°C at which cadmium and tellurium melt, hence, after an interval of about an hour, the perfect homogenization of the solution is achieved as an effect of thermal agitation.

Now, the mercury bath is introduced into the quartz tube and its temperature is progressively raised to value THg of the left part of the furnace. As a consequence a mercury vapour atmosphere is created with a pressure determined by the temperature, which is generally of about 230 °C. Hence the long absorption phase of the mercury by the initial solution of cadmium in tellurium can start, which solution progressively becomes a cadmium and mercury solution in tellurium. At the same time with the formation phase, there is a further homogenization phase of the solution.

Partial mercury pressure of the solution is exactly equal to mercury bath pressure at temperature Thg. Hence, by controlling temperature THg by the two-zone furnace, mercury concentration in growth solution is controlled. Mercury concentration, as well as the concentration of previously weighted cadmium, determines the composition of solid single-crystal layers on the substrate.

The substrate is then brought into contact, as already described, with the solution in a slight-supersaturation condition, and is left in this position for some tens minutes, so as to obtain the desired thickness of deposited solid.

The temperature profiles in the solution and in the mercury bath versus time are plotted on cartesian diagram of Fig.2 and are respectively denoted by A and B.

The part of curve A which goes from origin to point 1, of the duration of about one hour, corresponds to the homogenization period of the solution of cadmium in tellurium. Among points 1 and 2, for the duration of about two hour and half, there is formation and homogenization of the solution of cadmium and mercury in tellurium, hence, with a temperature decrease of 2 or 3 degrees for half an hour, one reaches point 3, where the solution can be found in supersaturation condition. Then the epitaxial growth can start, which really begins at point 4 and ends at point 5.

Curve B, relevant to mercury bath temperature, starts from room temperature an hour after growth solution heating has started and reaches the temperature necessary to generate the desired partial pressure of mercury vapur. The solution has been formed in correspondance with point 6 and only its composition must be preserved during epitaxial growth on the substrate. To this aim also the mercury bath is submitted to controlled cooling of some tenths of degree per minute, comprised between points 6 and 7. Yet, to avoid variations in the solution composition the ratio among time derivatives of the temperatures must be equal to the ratio among the temperature derivatives of corresponding vapour pressures.

Operative conditions and the results reached during a typical growth process of single-crystal mercury cadmium telluride layers are now described.

To obtain layers with 39% of mercury, 11% of cadmium and 50% of tellurium, in the crucible well a solution is generated composed of a mole fraction of mercury equal to 0.155 and a mole fraction of cadmium equal to 0.0075. Its homogenization can be advantageously performed at a temperature of a few degrees higher than the equilibrium temperature $T_{sol}$, equal to 472.5°C, while at a 2 or 3-degree lower temperature supersaturation condition allowing growth to start is obtained. Mercury bath temperature $T_{Hg}$ during formation phase is of about 234 °C and during growth phase decreases by 0.2 °C/min, with a ratio among gradients equal to about 1.2.

Thus single-crystal layers of a thickness ranging from 20 to 40 μm and of good morphology are obtained on a 3 cm² substrate, using 0.08-mole solution. The mercury weight incorporated by such a solution during its formation and homogenization phase is 2.487 g.

In case different-composition single-crystal layers are desired, different composition solutions are formed in the two crucible wells starting from different contents of weighted cadmium, and the substrate is brought into contact with either composition alternately for the time necessary to the deposition of solid thickness desired.

## Claims

1. A process for fabricating single-crystal mercury cadmium telluride layers by epitaxial growth on a cadmium telluride substrate, performed inside a reactor (TQ) with two communicating zones maintained at different and controlled temperatures, characterized in that:
- weighed amounts of cadmium and tellurium are placed in a well inside the reactor (TQ) in the higher-temperature zone and are melted and homogenized, so as to obtain a solution of cadmium in tellurium;
- a mercury bath (BM) is placed inside the reactor in the lower-temperature zone and is heated so as to obtain a mercury vapour atmosphere in the whole reactor;
- due to the absorption of vapour state mercury, the above solution is converted into a solution of cadmium and mercury in tellurium and homogenized as an effect of thermal agitation at the higher temperature;
- solution and mercury bath are slowly cooled down so as to produce the solution supersaturation and keep its composition constant;
- the substrate (SS) is brought into contact with the solution and the epitaxial growth of single-crystal mercury cadmium telluride is carried out.

2. A process as in claim 1, characterized in that the desired composition of said solution of mercury in tellurium is obtained by acting on the lower temperature of the mercury bath (BM).

3. A process as in claim 2, characterized in that the composition of said solution is maintained constant all over epitaxial growth by contemporarily reducing the solution and mercury bath temperatures, but maintaining the ratio between time derivatives of said temperatures equal to the ratio between temperature derivatives of respective partial pressures.

## Patentansprüche

1. Verfahren zum Erzeugen von monokristallinen Quecksilber-Cadmium-Tellurid-Schichten durch epitaxiales Wachstum auf einem Cadmium-Tellurid-Substrat, das man innerhalb eines Reaktors (TQ) mit zwei miteinander kommunizierenden Bereichen durchführt, die auf unterschiedlichen und gesteuerten Temperaturen gehalten werden, dadurch gekennzeichnet, daß man:
- gewichtsmäßig bestimmte Mengen von Cadmium und Tellur in eine Schale innerhalb des Reaktors (TQ) im Bereich der höheren Temperatur anordnet und sie schmilzt und homogenisiert und so eine Lösung des Cadmiums im Tellur erhält;
- ein Quecksilberbad (BM) im Reaktor im Bereich der niedrigeren Temperatur anordnet und es so erwärmt, daß man im gesamten Reaktor eine Quecksilberdampfatmosphäre erhält;
- aufgrund der Absorbtion von im Dampfzustand befindlichem Quecksilber die beschriebene Lösung in eine Lösung von Cadmium und Quecksilber in Tellur umwandelt und sie als Effekt der thermischen Agitation bei der höheren Temperatur homogenisiert;
- die Lösung und das Quecksilberbad langsam so abkühlt, daß eine Übersättigung der Lösung entsteht und ihre Zusammensetzung konstant bleibt;
- das Substrat (SS) in Kontakt mit der Lösung bringt und das epitaxiale Wachstum des monokristallinen Quecksilber-Cadmium-Tellurids durchführt.

2. Verfahren nach Anspruch 1, dadurch gekennzeichnet, daß man die gewünschte Zusammensetzung der Quecksilberlösung im Tellur durch Einwirken auf die niedrigere Temperatur des Quecksilberbads (BM) erhält.

3. Verfahren nach Anspruch 2, dadurch gekennzeichnet, daß man die Zusammensetzung der Lösung während des gesamten epitaxialen Wachstums dadurch konstant hält, daß man gleichzeitig die Temperaturen der Lösung und des Quecksilberbads erniedrigt, während man das Verhältnis zwischen den Ableitungen dieser Temperaturen über der Zeit gleich dem Verhältnis zwischen den Ableitungen der jeweiligen Teildrücke über der Temperatur hält.

## Revendications

1. Procédé pour la fabrication de couches monocristallines de tellurure de cadmium et de mercure par croissance épitaxiale sur un substrat de tellurure de cadmium, menée à l'intérieur d'un réacteur (TQ) à deux zones communicantes maintenues à des températures différentes et contrôlées, caractérisé en ce que:

- des quantités pesées de cadmium et de tellure sont placée dans un puits creux dans le réacteur (TQ) dans la zone de température plus élevée et sont fondues et homogénéisées, de manière à obtenir une solution de cadmium dans le tellure;
- un bain de mercure (BM) est placé dans le réacteur dans la zone de température moins élevée et est chauffé de manière à obtenir une atmosphère de vapeur de mercure dans tout le réacteur;
- par absorption de mercure à l'état de vapeur, ladite solution est transformée en une solution de cadmium et de mercure dans le tellure et homogénéisée par effet de l'agitation thermique à la température plus élevée;
- la solution et le bain de mercure sont refroidis lentement de manière à provoquer la sursaturation de la solution et à en maintenir la composition constante;
- le substrat (SS) est placé en contact avec la solution et la croissance épitaxiale de tellurure de cadmium et de mercure monocristallin est effectuée.

2. Procédé selon la revendication 1, caractérisé en ce que la composition désirée de ladite solution de mercure dans le tellure s'obtient en agissant sur la température moins élevée à laquelle on a porté le bain de mercure (BM).

3. Procédé selon la revendication 2, caractérisé en ce que la composition de ladite solution est maintenue constante au cours de la croissance épitaxiale par réduction simultanée de la température de la solution et de celle du bain de mercure, mais avec maintien du rapport entre les dérivées par rapport au temps desdites températures égal au rapport entre les dérivées par rapport à la température des pressions partielles respectives.

FIG. 1

FIG. 2